# EUROPEAN PATENT SPECIFICATION

(11) **EP 2 544 297 B1**
(45) Date of publication and mention of the grant of the patent: **01.03.2017**
(21) Application number: 12171289.7
(22) Date of filing: 08.06.2012
(51) Int. Cl.: H01P 1/205

(54) **Adjustable resonator filter and method for adjusting coupling between resonator cavities**
Anpassbarer Resonatorfilter und Verfahren zur Anpassung der Ankopplung zwischen Resonatorhohlräumen
Filtre de résonateur réglable et procédé de réglage de couplage entre les cavités de résonateur

(30) Priority: 06.07.2011 FI 20115721
(43) Date of publication of application: 09.01.2013
(73) Proprietor: Intel Corporation, Santa Clara, CA 95054 (US)
(72) Inventor: Puoskari, Jukka, 91910 Tupos (FI); Päri, Petri, 90440 Kempele (FI)
(74) Representative: Goddar, Heinz J.

(56) References cited:
- EP-A2- 0 759 645
- WO-A1-01/84662
- WO-A1-2004/084340
- US-A- 3 693 115
- US-A- 4 307 357

## Description

The invention relates to an adjustable resonator filter, which has a casing made up of a bottom, walls and a lid, which casing functions as a ground for a transmission path, which is divided with conductive partitions into resonator cavities, and on the transmission path of the resonator filter there is a coupling opening in the partitions separating subsequent cavities. The invention further relates to a method for adjusting the coupling between resonator cavities.

Cavity resonators are generally used in communications networks for making filters, especially when the effect of the signal to be transferred is relatively large. This is due to the fact that losses caused by such resonator filters are small, which means only a slight attenuation of the efficiency signal. Additionally their response characteristics are easy to control and adjust even according to strict specifications.

Common radio-frequency resonators are various cavity and coaxial resonators, because they can be used to build filters, which have small losses and withstand relatively large capacities. The basic structure of the resonator comprises an internal conductor, an external conductor consisting of the side walls, a bottom and a lid. The bottom and the lid are in galvanic contact with the external conductor, and all three together form a closed resonator casing. Usually the lower end of the internal conductor is galvanically connected to the bottom and the upper end is in the air, whereby the transmission path formed by the resonator is short-circuited in its lower end and open in its upper end. The filter usually has two or more resonators coupled together.

In most filters, both the location and width of the pass band of the filter is meant to be fixed. In some filters the width of the pass band of the filter is meant to be constant, but the location of the pass band must be possible to select from within a certain total area. Thus an adjustment possibility for moving the pass band is needed in the filter in addition to the basic rigging. In order for the frequency response of the band pass filter to be according to requirements, the pass band thereof must on the one hand be in the right place on the frequency axis and on the other hand have the right width. In a resonator filter this requires that, on the one hand, the specific frequency of each resonator is correct and, on the other hand, the strength of the couplings between resonators is correct.

The width of the pass band is adjusted by altering the strength of the coupling between the resonators and at the inlet and outlet of the filter. The adjustment of the band width is based on arranging a so-called cross coupling between subsequent resonators with the same specific frequency, whereby they have a double resonance. When the coupling is thus further strengthened, the resonance peaks of the double resonance draw away from each other, which naturally has a widening effect on the band. At the production stage the band pass filter is in principle dimensioned so that the strength of the coupling between the middle resonators is the smallest and when moving from the middle toward the ends of the filter the strength of the coupling between the resonators grows. When all couplings are strengthened evenly, the band of the filter widens while the attenuation variation remains small in the pass band.

The adjustment of the strength of the coupling, or shorter the adjustment of the coupling, can be realized in several ways. One way is to equip the structure with metallic screws, so that these extend through the lid of the filter to the coupling openings between the resonators. When turning such a screw for example deeper into the coupling opening, the coupling between the resonators in question grows, which has a widening effect on the band. A disadvantage with using tuning screws is that the boundary surface between them and the surrounding metal can cause harmful passive intermodulation when using the filter. Additionally the electric contact in the threads can deteriorate over time, which causes changes in the tuning and an increase in losses in the resonator.

The coupling between two resonators can also be adjusted by means of a bendable tuning member arranged close to the coupling opening. A disadvantage with such a solution is that in a multi-resonator filter the tuning members may need to be bent in several stages to achieve the desired frequency response. The lid of the filter must be opened and closed with each adjustment, wherefore the tuning takes time and is relatively expensive.

Patent publication US 5805033 presents a known manner of adjusting the coupling between resonators of a filter. The filter has a casing made up of a bottom, outer walls and a lid, the space of which casing is divided with conductive partitions into resonator cavities. In order to realize the coupling between the resonators there is an opening in their partition, which extends from the lid to the bottom and which narrows toward the bottom. There is a tuning member in the coupling opening for adjusting the coupling, which tuning member is a circular metal plate parallel to the lid. This is attached to the lid by means of a screw bar extending outside of the filter casing. The above-mentioned problems arise in such an arrangement. With such an arrangement the adjustment area does not necessarily turn out linear.

Resonator filters are also known from EP 0 759 645 A2 or WO 01/84662 A1. An object of the invention is a solution by which the drawbacks and disadvantages relating to the prior art can be considerably reduced.

The objects of the invention are obtained with a coupling arrangement of a resonator, which is characterized by what is presented in the independent claims. Some advantageous embodiments of the invention are presented in the dependent claims.

The main idea of the invention is to adjust the coupling between two subsequent resonator cavities by forming an adjustment arrangement, which has a coupling space between two resonator cavities, in which space there is an inductive coupling member, the load of which is adjusted simultaneously with the coupling between the resonator cavities by moving the adjustment member in relation to the coupling member. The adjustment member advantageously remains in the coupling space, whereby it affects the resonators as little as possible.

An adjustable resonator filter according to one embodiment of the invention has a casing made up of a bottom, walls and a lid, which casing functions as a ground for a transmission path, which is divided with conductive partitions into resonator cavities, and on the transmission path of the resonator filter there is a coupling opening in the partitions separating subsequent cavities. According to one advantageous embodiment of the invention the casing has a coupling space by at least one partition, which space is open into both resonator cavities separated by the partition. The resonator filter has at least one inductive coupling member, which is arranged to extend through said coupling space into both resonator cavities, and said inductive coupling member is in electric contact with the casing at least in one of the resonator cavities. In said coupling space there is a moveable conductive adjustment piece, which has a minimum position for the coupling and a maximum position for the coupling. In the maximum position for the coupling the adjustment piece is in the immediate vicinity of the inductive coupling member, loading the inductive coupling member via the capacitive coupling, and in the minimum position of the coupling the adjustment piece is apart from the inductive coupling member. The adjustment piece is in said positions and in its path outside them at least partly outside the resonator cavities or in the area of the resonator cavities, where the electric and magnetic field are substantially at their minimum.

In one advantageous embodiment of the resonator according to the invention the coupling space is in the wall of the casing and extends substantially from the bottom to the lid.

In a second embodiment of the resonator according to the invention the inductive coupling member has a first end and a second end and it is by its first end attached to the wall of the resonator cavity and its second end is in the second resonator cavity.

In a third embodiment of the resonator according to the invention the second end of the inductive coupling member is detached from the wall of the resonator cavity.

In a fourth embodiment of the resonator according to the invention the inductive coupling member is substantially electrically separated from the walls of the coupling space, i.e. thus it does not have substantial electric contacts with the walls of the coupling space.

In a fifth embodiment of the resonator according to the invention the inductive coupling member has a protruding part between its first and second end, in its part in the coupling space, close to which protruding part the adjustment piece is arranged in the maximum position for the coupling.

In a sixth embodiment of the resonator according to the invention the shape of the protruding part is substantially the same as the shape of at least some part close to the inductive coupling member of the part of the adjustment piece.

In a seventh embodiment of the resonator according to the invention the adjustment piece has a manoeuvring arrangement, by means of which the location of the adjustment piece can be altered from outside the resonator filter. In an eighth embodiment of the resonator according to the invention the manoeuvring arrangement is arranged to move several adjustment pieces simultaneously.

In a ninth embodiment of the resonator according to the invention the adjustment piece is arranged to be moved substantially in the longitudinal direction of the filter, i.e. in the direction of the subsequent resonator cavities.

In a tenth embodiment of the resonator according to the invention the adjustment piece is substantially on top of the same spot on the inductive coupling piece and the distance from the adjustment piece to the inductive coupling piece is arranged to be adjustable.

In a method according to the invention for adjusting the coupling between resonator cavities, the resonator cavities have a wall, which consists of a bottom, a wall and a lid and a conductive partition separating adjacent resonator cavities. The partition separating subsequent cavities has a coupling opening. According to an advantageous embodiment of the method according to the invention a coupling space is formed in the partition in the wall of two resonator cavities, which coupling space is open into both resonator cavities separated by said partition. Between these resonator cavities there is an inductive coupling member, which is arranged to extend through said coupling space into both resonator cavities. Said inductive coupling member is in electric contact with the casing at least in one of the resonator cavities. In said coupling space there is a moveable conductive adjustment piece, which has at least one minimum position for the coupling and maximum position for the coupling. In the method the adjustment piece is moved between the minimum position for the coupling and the maximum position for the coupling, whereby in the maximum position the adjustment piece is close to the inductive coupling member and loads it via the capacitive coupling and simultaneously increases the strength of the coupling between the resonator cavities, and in the minimum position the adjustment piece is apart from the coupling member and its effect on the coupling between the resonator cavities is at its minimum. The adjustment piece is set in either said position or in some other spot on the path of the adjustment piece in order to obtain the desired strength of the coupling.

It is an advantage of the invention that it can easily be adapted to different resonator filter types and it is structurally simple. The adjustment parts can additionally be made of metal. These make possible a decrease in the production costs.

It is further an advantage of the invention that the adjustment piece is far from the conductors of the resonators, whereby effects on the properties of the resonators are slight with the arrangement according to the invention.

It is also an advantage of the invention that a large and linear adjustment area is easily obtained with the arrangement in accordance thereto. The arrangement according to the invention is also easy to automate.

Further by means of the invention the adjustment of the filter can be done from outside the resonance cavities.

In the following, the invention will be described in detail. In the description, reference is made to the appended drawings, in which
- Figure 1: shows an example of a resonator filter according to the invention seen from above,
- Figure 2: shows the resonator filter of Figure 1 as a side cross-section,
- Figure 3: shows a second example of a resonator filter according to the invention seen from above,
- Figure 4: shows an example of the different stages of the adjustment of a resonator filter according to the invention,
- Figure 5: shows changes in strength of the coupling of a resonator filter according to the invention as a function of the frequency,
- Figure 6: shows a third example of a resonator filter according to the invention seen from above.

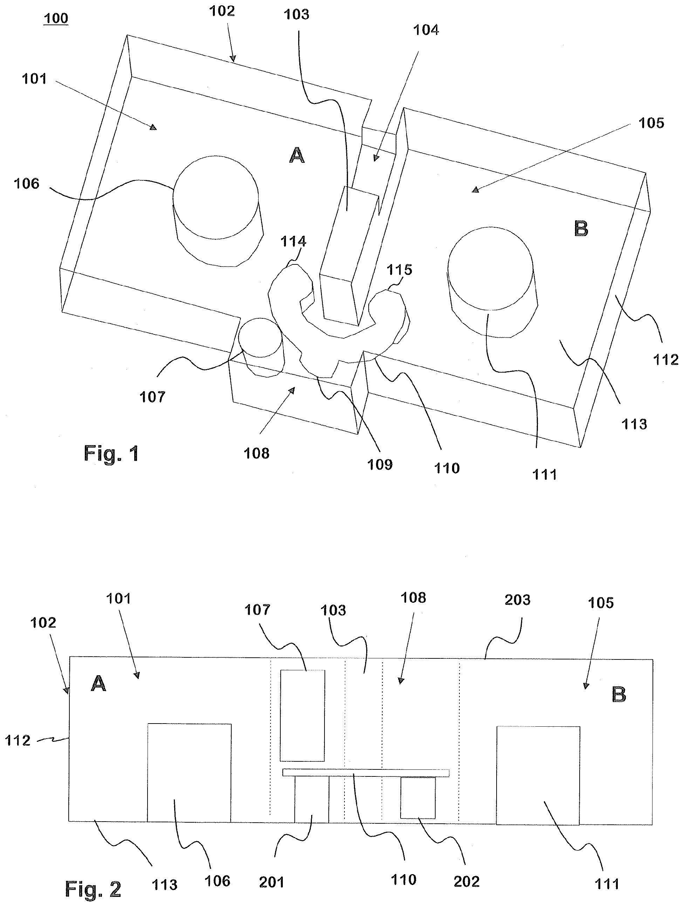

Figure 1 shows a simplified example of a resonator filter 100 according to the invention as a perspective drawing. The filter has a conductive casing, the shell 102 of which is made up of a bottom 113, walls 112 and a lid. In the figure the lid is removed for illustrative purposes and the walls are partly transparent. The filter has two resonators, a first resonator A and a second resonator B, which are separated by a partition 103. The partition has a coupling opening 104. The first resonator has a first resonator cavity 101 and a first internal conductor 106 of the resonator, which conductor is by its lower end connected to the bottom in a galvanic manner and the upper end of which is in the air. The second resonator correspondingly has a second resonator cavity 105 and a second internal conductor 111 of the resonator. The sides of the resonator cavities are substantially shaped like parallelograms.

In the shell of the casing of the resonator filter 100 there is a coupling space 108. This is formed by the partition 103, so that the coupling space opens into the first resonator cavity 101 and the second resonator cavity 105 separated by the partition. The coupling space is advantageously placed so that it is as far away as possible from the internal conductors of the resonators. In the case shown in the figure it is placed in the wall of the shell by the end of the partition where the distance to the coupling opening 104 is greater. This applies in a case where the coupling opening is located asymmetrically. By placing the coupling space as far away as possible from the coupling opening, disturbances caused by the members placed in the coupling space and a tuning member possibly located in the coupling opening to each other are avoided. The coupling space is in the case according to the example formed by making a recess in the wall, which recess extends from the bottom of the shell to the lid. The bottom of the coupling space is thus the bottom of the filter and the upper surface of the coupling space is the lid of the filter. The size of the coupling space is further increased by shortening the partition, so that it no longer is as long as the width of the resonator cavity. In some embodiments the partition can be continued so that it extends into the recess of the coupling space formed in the wall. Thus the coupling space would be a passage-like structure, which has a curve. The coupling space can be placed also elsewhere in the shell than in the wall. Additionally it can also extend into different parts of the shell. For example in the example according to the figure, the coupling space can extend upward into the lid. Thus the coupling space can be higher than the height of the resonator cavity.

The resonator filter 100 has an inductive coupling member 110 between the first resonator A and the second resonator B. The inductive coupling member is conductive and it is used to form an inductive coupling between the resonators. The strength of the coupling is proportional to the electric properties of the inductive coupling member. The coupling member has a first end 114 and a second end 115. The coupling member is attached by its first end to the bottom of the resonator cavity 101 of the resonator A with a support part. The support part is made of a conductive material. The support part keeps the coupling element apart from the bottom. In the case according to the example the coupling member is a curved plate, in the midpoint of which there is a protrusion 109. The protrusion can also be in some other spot on the coupling member, but it is advantageously in the part of the coupling member, which is in the coupling space. The protrusion can be made for example by shaping the coupling member for example by bending or stretching. The protrusion can also be attached to the coupling member in some known manner. The coupling member is placed in the resonator filter so that its midpoint is in the coupling space 108. In other words the first end of the coupling member is in the first resonator cavity and the second end of the coupling member in the second resonator cavity 105. There is an induction piece in the second end of the coupling member. The coupling member is thus in contact with the shell only by its first end. The coupling member can also be manufactured from one part, whereby the first end of the coupling member is a support part and the second end is an induction piece.

In the coupling space 108 there is an adjustment piece 107. The adjustment piece is made from a conductive or a dielectric material and it is moveable. In the case according to the figure the adjustment piece has a manoeuvring arrangement, which extends through the lid. The adjustment piece is insulated from the manoeuvring arrangement or the manoeuvring arrangement is insulated from the lid. One embodiment is a screw penetrating the lid, which screw has a plastic protective sleeve. The protective sleeve travels in a gap in the lid, which gap determines the path, which the adjustment piece can travel. The adjustment piece is not in contact with the shell 102 of the casing of the resonator filter 100. In the case according to the figure the adjustment piece is a cylindrical piece, which is moveable in the coupling space in a direction, which is substantially transverse to the partition 103. The lower surface of the cylinder is toward the bottom of the filter and the upper surface is toward the lid. The bottom of the adjustment piece, i.e. the lower surface of said cylinder, is above the upper surface of the coupling member 110.

The adjustment piece 107 has at least one minimum position for the coupling and maximum position for the coupling, and the adjustment piece can be moved at least between these positions. In the minimum position for the coupling the adjustment piece is as far away as possible from the coupling member 110. Thus the electric effect of the adjustment piece on the coupling member is at its minimum. In the maximum position for the coupling the adjustment piece is on top of the coupling member and advantageously the protrusion 109 of the coupling member and the electric effect of the adjustment piece on the coupling member is at its maximum. When the adjustment piece is in the minimum position for the coupling, the coupling between the resonators caused by the inductive coupling member is at its minimum and its effect on the bandwidth of the filter is at its minimum. In the maximum position for the coupling the coupling between the resonators is at its maximum and its effect on the bandwidth of the filter is at its maximum. The bandwidth of the filter can be affected also in other ways simultaneously with the arrangement according to the invention. When the adjustment piece moves onto the coupling member, a capacitive coupling is generated between them. The adjustment piece and the coupling member are thus not in contact with each other. The adjustment piece alters the electric properties of the inductive coupling member and simultaneously the inductive coupling between the resonators. The movement of the adjustment piece onto the coupling member can be compared to a situation, where a capacitor would be connected to the coupling member, the surface area and simultaneously the capacitance of which capacitor can be adjusted. The bottom of the adjustment piece and the protrusion of the coupling member or the part thereof, onto which the adjustment piece is arranged to come, can have been shaped to correspond to each other, so that the surface area of the capacitive connection could be made larger than with a smooth surface. These could be wave or serrated forms. In this example the adjustment piece moves substantially in the direction of the surface of the adjustment piece, but the adjustment piece can in some cases also be moved vertically, so that its bottom is substantially in the same spot above the coupling member and its distance from the surface of the coupling member is adjusted. Although in this example the adjustment piece is above the coupling member, i.e. between the surface of the coupling member and the lid of the filter, the adjustment piece can also be placed below the coupling member, i.e. between the coupling member and the bottom of the filter or between the coupling member and the wall of the coupling space. The distances of the adjustment piece to the surfaces of the shell of the filter, such as for example the bottom and the lid, remain substantially constant when moving the filter piece, whereby changes in the load of the coupling member and simultaneously changes in the coupling remain linear. By selecting the size and electric properties of the adjustment piece, the adjustment tolerance of the bandwidth of the filter can be changed.

The adjustment piece 107 is advantageously in every part of its path at least partly in the coupling space 108. If the adjustment piece must, for example in the minimum position for the coupling in order to get it as far away as possible from the inductive coupling member 110, be moved completely or partly into the resonator cavity, a place is selected in the resonator cavity, where the electric and magnetic fields are at their minimum, whereby the adjustment piece affects the operation of the resonator as little as possible.

Figure 2 shows a side cross-section of the resonator filter of Figure 1. The shell 102 of the filter is made up of a bottom 113, walls 112 and a lid 203. The first resonator A and the second resonator B are separated by a partition 103. Between the resonators in the wall of the shell there is a coupling space 108, which is open into the first resonator cavity 101 and the second resonator cavity 105. The partition and the coupling space are marked with a dotted line in the figure. An inductive coupling piece 110 is attached by its first end to the bottom of the first resonator cavity with a support piece 201. The support piece is made of a conductive material. The coupling piece extends through the coupling space into the second resonator cavity, where there is an induction piece 202 in the second end of the coupling piece. The induction piece is not in contact with the walls of the second resonator cavity. The induction piece is made of a conductive material. The support piece, the coupling piece and the induction piece are advantageously made of the same material. Even though the induction piece is in the example according to the figure placed so that it comes close to the bottom of the resonator cavity, it can also be placed in some other manner. The induction piece is in all cases not necessarily needed, it is enough that the coupling piece reaches the second resonator cavity. In some cases the coupling piece can have several support pieces, some of which may be in the coupling space. In the coupling space there is additionally an adjustment piece 107. The adjustment piece is placed so that it can be moved close to the coupling piece in the coupling space.

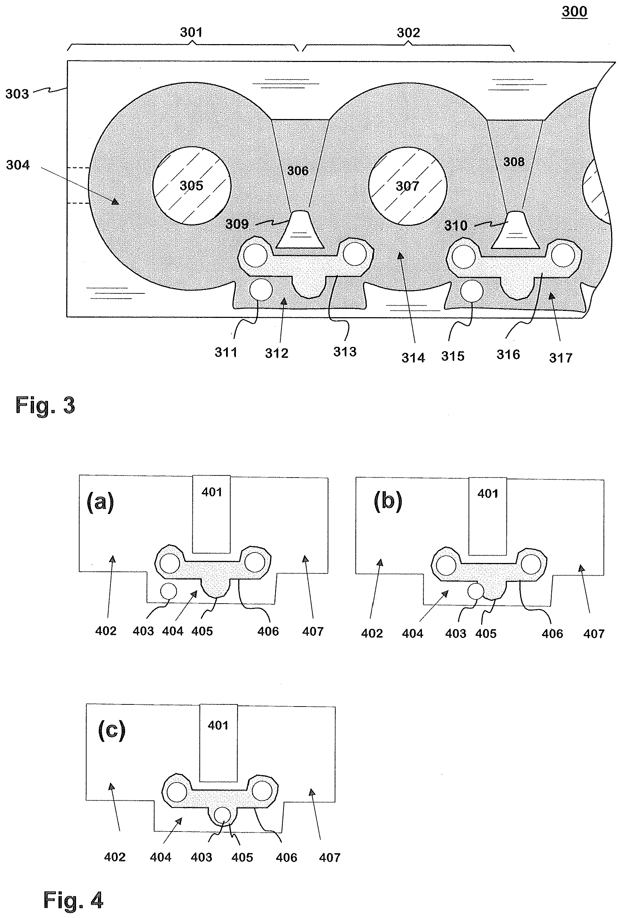

Figure 3 shows a second example of the resonator filter 300. The resonator filter has a casing 303 and several resonators. The figure shows a first resonator 301 and a second resonator 302. The first resonator has a first internal conductor 305 and a first resonator cavity 304. The second resonator has a second internal conductor 307 and a second resonator cavity 314. Adjacent resonators are separated by partitions. In the figure the first resonator and the second resonator are separated by a first partition 309 and the second and third resonator (partly shown in the figure) are separated by a second partition 310. In the case according to the example the resonators and the internal conductors of the resonator are cylindrical. The partitions have coupling openings connecting the resonator cavities. The first partition has a first coupling opening 306 and the second partition has a second coupling opening 308. In the wall of the filter casing there is by the partition a coupling space, which is open into both adjacent resonator cavities. The resonators are through the coupling space connected by an inductive coupling member. By the first partition there is a first coupling space 312 and by the second partition there is a second coupling space 317. The first coupling space has a first coupling member 313 and the second coupling space has a second coupling member 316. The coupling between the first and second resonator formed by the first coupling member is altered with a first adjustment piece 311 in the first coupling space and correspondingly the coupling between the second and third resonator is altered with a second adjustment piece 315. For the operation and adjustment of the resonators and the filters formed by them it is advantageous that the adjustment piece disturbs the operation of the resonator as little as possible. In the example according to the figure the side walls of the coupling spaces form an angle with the end wall of the coupling space, i.e. with the wall in the direction of the wall of the filter casing, which angle is smaller than a right angle. Thus the wall of the resonator cavity and the side wall of the coupling space form a pocket-like structure, into which the adjustment piece can be moved in the minimum position for the coupling. When in this pocket-like structure, the adjustment piece affects the operation and properties of the resonator and coupling member as little as possible.

Figure 4 shows an example of the different stages of the adjustment of a resonator filter according to the invention. The figure is simplified for illustrative purposes. The figure shows a first resonator cavity 402, a second resonator cavity 407, a partition 401 separating the cavities, a coupling space 404 in the filter wall by the partition, a moveable adjustment piece 403 in the coupling space and an inductive coupling member 406 connecting the resonator cavities. The coupling member is in contact with the bottom of the first resonator cavity and it extends through the coupling space into the second resonator cavity. The coupling member has a protrusion 405 substantially in its midpoint. In Figure 4a the adjustment piece is in the minimum position for the coupling and it is clearly apart from the coupling member. By shaping the coupling member and by selecting its attaching point in the resonator cavity to be farther from the coupling space than what is shown in Figure 4, the coupling member can when necessary be placed farther from the adjustment piece, when it is in the minimum position for the coupling. In Figure 4b the adjustment piece is moved toward the protrusion. Thus the coupling caused by the coupling member between the resonators is strengthened. In Figure 4c the adjustment piece is in the maximum position for the coupling, i.e. it is completely on top of the coupling member. Thus the load caused by the adjustment piece on the coupling member is at its maximum and the strength of the coupling between the resonators caused by the coupling member is as its maximum. The adjustment piece can be arranged to move also over the protrusion of the coupling member to the opposite side than where the adjustment piece was in Figure 4a. In some cases the coupling member can be made asymmetrical. Several protrusions of different shapes can also be arranged in the coupling member.

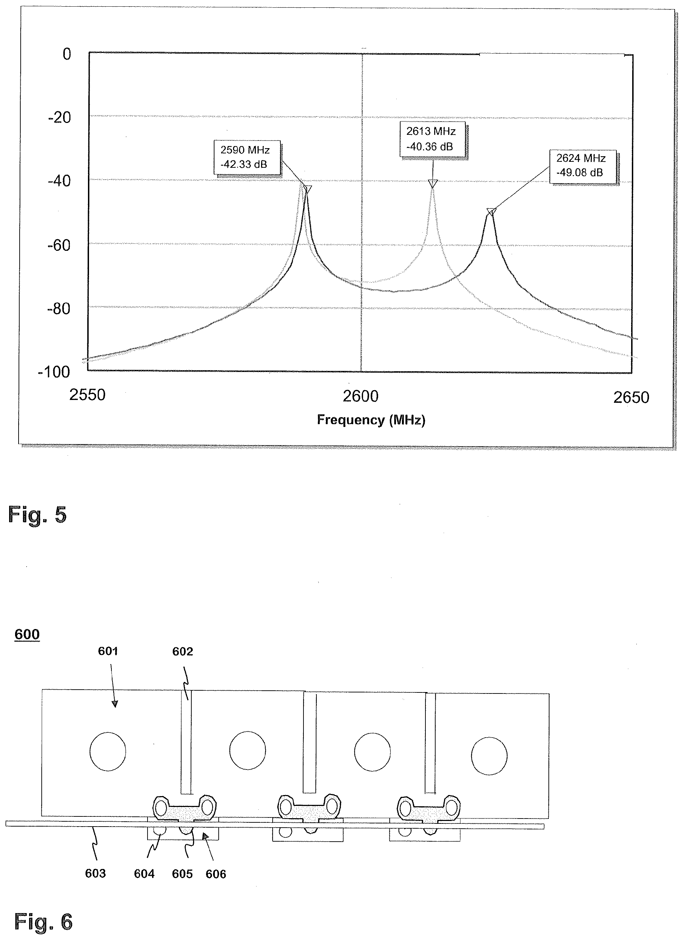

Figure 5 shows an example of a measured changed in the bandwidth with an arrangement according to the invention. The vertical axis shows the strength of the coupling in decibels and the horizontal axis shows the frequency. The light curve shows the situation when the adjustment piece is in the minimum position for the coupling. The distance of the resonance peaks is about 23 MHz. The dark curve on the other hand shows the situation when the adjustment piece is in the maximum position for the coupling. The distance of the resonance peaks is in this case about 34 MHz. The distance of the resonance peaks can thus be adjusted by over 10 MHz. With the arrangement according to the invention the adjustment is also quite linear and thus easily controlled.

Figure 6 shows a third example of a resonator filter 600 according to the invention seen from above. The filter has four subsequent resonators 601, which are separated by partitions 602. A coupling space 606 has been made in the filter wall by each partition. Between subsequent resonators there is an inductive coupling piece 605, the different ends of which are in different resonators. The coupling spaces have adjustment pieces, which are attached to a manoeuvring member 603. Because all the adjustment pieces are attached to the same manoeuvring member, all the adjustment pieces and simultaneously the couplings caused by all the inductive coupling pieces can at the same time be adjusted by moving it. This speeds up the adjustment significantly in comparison to a situation where each coupling would be adjusted separately. It must be noted that the properties of each coupling piece and adjustment piece, such as the dimensions or electric properties, may be different, even if they are arranged to be adjusted simultaneously.

The definitions "horizontal", "vertical", "lower", "upper", "downwards", "upwards" and "from above" and corresponding directions in this description and claims refer to the position of the filter, where the lid and the bottom of the filter casing are in a horizontal position, the lid being higher, and these definitions have nothing to do with the use position of the filter.

Some advantageous embodiments according to the invention have been described above. The invention is not limited to the solutions described above, but the inventive idea can be applied in numerous ways within the scope of the claims.

## Claims

1. An adjustable resonator filter (100; 300; 600), which has a casing made up of a bottom (113), walls (112) and a lid (203), which casing functions as a ground for a transmission path, which casing is divided with conductive partitions (103; 309, 310; 401; 602) into resonator cavities (101, 105; 304, 402, 407), and on the transmission path of the resonator filter there is a coupling opening (104; 306, 308) in the partitions separating subsequent cavities, **characterised in that** there is a coupling space (108; 312, 317; 404; 606) in the casing formed by at least one of the partitions having a coupling opening, which coupling space is separated from the coupling opening and is open into both resonator cavities separated by the partition, which resonator filter has at least one inductive coupling member (110; 313, 316; 406; 605), which is arranged to extend through said coupling space into both resonator cavities and said inductive coupling member is in electric contact with the casing in one of the resonator cavities, and in said coupling space there is a moveable conductive adjustment piece (107; 311, 315; 403; 604), which has a minimum position for the coupling and a maximum position for the coupling, in which maximum position for the coupling the adjustment piece is in the immediate vicinity of the inductive coupling member, loading the inductive coupling member via the capacitive coupling, and in which minimum position of the coupling the adjustment piece is apart from the inductive coupling member, and the adjustment piece is in said positions and on its path outside them at least partly outside the resonator cavities or in the area of the resonator cavity, where the electric and magnetic field are substantially at their minimum.

2. The resonator filter (100; 300; 600) according to claim 1, **characterised in that** the coupling space (108; 312, 317; 404; 606) is in the wall of the casing and extends substantially from the bottom to the lid.

3. The resonator filter (100; 300; 600) according to any of the claims 1-2, **characterised in that** the inductive coupling member (110; 313, 316; 406; 605) has a first end (114) and a second end (115) and it is by its first end attached in the wall of the resonator cavity (101; 304; 402) and its second end is in the second resonator cavity (105; 314; 407).

4. The resonator filter (100; 300; 600) according to claim 3, **characterised in that** the second end (115) of the inductive coupling member (110; 313, 316; 406; 605) is detached from the wall of the resonator cavity.

5. The resonator filter (100; 300; 600) according to any of the claims 1-4, **characterised in that** the inductive coupling member (110; 313, 316; 406; 605) is substantially electrically separate from the walls of the coupling space (108; 312, 317; 404; 606).

6. The resonator filter (100; 300; 600) according to any of the claims 1-5, **characterised in that** the inductive coupling member (110; 313, 316; 406; 605) has between its first end (114) and second end (115) in its part in the coupling space (108; 312, 317; 404; 606) a protruding part (109; 405), in the vicinity of which the adjustment piece (107; 311, 315; 403; 604) is arranged in the maximum position for the coupling.

7. The resonator filter (100; 304; 600) according to claim 6, **characterised in that** the shape of the protruding part (109; 405) is substantially at least partly the same as the shape of a part close to the inductive coupling member (108; 312, 317; 404; 606) of a part of the adjustment piece (107; 311, 315; 403; 604).

8. The resonator filter (100; 300; 600) according to any of the claims 1-7, **characterised in that** the adjustment piece (107; 311, 315; 403; 604) has a manoeuvring arrangement (603), by means of which the location of the adjustment piece can be altered from outside the resonator filter.

9. The resonator filter (100; 300; 600) according to claim 8, **characterised in that** the manoeuvring arrangement (603) is arranged to move several adjustment pieces (107; 311, 315; 403; 604) simultaneously.

10. The resonator filter (100; 300; 600) according to any of the claims 1-9, **characterised in that** the adjustment piece (107; 311, 315; 403; 604) is arranged to be moveable substantially in the longitudinal direction of the filter, i.e. in the direction of the subsequent resonator cavities.

11. The resonator filter (100; 300; 600) according to any of the claims 1-9, **characterised in that** the adjustment piece (107; 311, 315; 403; 604) is substantially on the same spot of the inductive coupling member (110, 313, 316, 406, 605) and the distance of the adjustment piece to the inductive coupling member is arranged to be adjustable.

12. A method for adjusting the coupling between resonator cavities, which resonator cavities have a wall, which consists of a bottom, a wall and a lid and a conductive partition separating adjacent resonator cavities, and the partition separating subsequent cavities has a coupling opening, **characterised in that** a coupling space is formed by the partition, which coupling space is separated from the coupling opening and is open into both resonator cavities separated by said partition, between which resonator cavities there is an inductive coupling member, which is arranged to extend through the coupling space into both resonator cavities and said inductive coupling member is in electric contact with the casing in one of the resonator cavities, and in said coupling space there is a moveable conductive adjustment piece, which has at least one minimum position for the coupling and maximum position for the coupling, and the method consists of stages, where the adjustment piece is moved between the minimum position for the coupling and the maximum position for the coupling, whereby in the maximum position the adjustment piece is close to the inductive coupling member and loads it via the capacitive coupling and simultaneously increases the strength of the coupling between the resonator cavities and in the minimum position for the coupling the adjustment piece is apart from the coupling member and its effect on the coupling between the resonator cavities is at its minimum, and the adjustment piece is set in either said position or in some other spot on the path of the adjustment piece in order to obtain a desired strength for the coupling.

## Patentansprüche

1. Anpassbares Resonatorfilter (100; 300; 600), das ein Gehäuse besitzt, das aus einem Boden (113), Wänden (112) und einem Deckel (203) gebildet ist, wobei das Gehäuse als eine Masse für einen Übertragungspfad dient, wobei das Gehäuse durch leitfähige Trennelemente (103; 309, 310; 401; 602) in Resonatorhohlräume (101, 105; 304, 402, 407) unterteilt ist und eine Kopplungsöffnung (104; 306, 308) in den Trennelementen, die die aufeinander folgenden Hohlräume trennt, auf dem Übertragungspfad des Resonatorfilters vorhanden ist, **dadurch gekennzeichnet, dass** in dem Gehäuse ein Kopplungsraum (108; 312, 317; 404; 606) vorhanden ist, der durch mindestens eines der Trennelemente gebildet ist, die eine Kopplungsöffnung besitzen, wobei der Kopplungsraum von der Kopplungsöffnung getrennt ist und in beide Resonatorhohlräume, die durch das Trennelement getrennt sind, mündet, wobei das Resonatorfilter mindestens ein induktives Kopplungselement (110; 313, 316; 406; 605) besitzt, das dazu ausgelegt ist, sich durch den Kopplungsraum in beide Resonatorhohlräume zu erstrecken, und wobei das induktive Kopplungselement in einem der Resonatorhohlräume in elektrischem Kontakt mit dem Gehäuse ist und wobei ein bewegliches leitendes Anpassungsstück (107; 311, 315; 403; 604) in dem Kopplungsraum vorhanden ist, das eine Minimalposition für die Kopplung und eine Maximalposition für die Kopplung besitzt, wobei sich das Anpassungsstück in der Maximalposition für die Kopplung in der unmittelbaren Umgebung des induktiven Kopplungselements befindet, wodurch es das induktive Kopplungselement über die kapazitive Kopplung lädt, und wobei sich das Anpassungsstück in der Minimalposition der Kopplung von dem induktiven Kopplungselement entfernt befindet und wobei sich das Anpassungsstück in den Positionen und auf seinem Pfad, der davon außerhalb liegt, mindestens teilweise außerhalb der Resonatorhohlräume oder in dem Bereich des Resonatorhohlraums, wo das elektrische und magnetische Feld im Wesentlichen bei ihrem Minimum liegen, befindet.

2. Resonatorfilter (100; 300; 600) nach Anspruch 1, **dadurch gekennzeichnet, dass** sich der Kopplungsraum (108; 312, 317; 404; 606) in der Wand des Gehäuses befindet und sich im Wesentlichen von dem Boden bis zu dem Deckel erstreckt.

3. Resonatorfilter (100; 300; 600) nach einem der Ansprüche 1-2, **dadurch gekennzeichnet, dass** das induktive Kopplungselement (110; 313, 316; 406; 605) ein erstes Ende (114) und ein zweites Ende (115) besitzt und es an seinem ersten Ende an der Wand des Resonatorhohlraums (101; 304; 402) befestigt ist und sein zweites Ende sich in dem zweiten Resonatorhohlraum (105; 314; 407) befindet.

4. Resonatorfilter (100; 300; 600) nach Anspruch 3, **dadurch gekennzeichnet, dass** das zweite Ende (115) des induktiven Kopplungselements (110; 313, 316; 406; 605) von der Wand des Resonatorhohlraums losgelöst ist.

5. Resonatorfilter (100; 300; 600) nach einem der Ansprüche 1-4, **dadurch gekennzeichnet, dass** das induktive Kopplungselement (110; 313, 316; 406; 605) von den Wänden des Kopplungsraums (108; 312, 317; 404; 606) im Wesentlichen elektrisch getrennt ist.

6. Resonatorfilter (100; 300; 600) nach einem der Ansprüche 1-5, **dadurch gekennzeichnet, dass** das induktive Kopplungselement (110; 313, 316; 406; 605) zwischen seinem ersten Ende (114) und seinem zweiten Ende (115) in seinem Abschnitt in dem Kopplungsraum (108; 312, 317; 404; 606) einen vorstehenden Abschnitt (109; 405) besitzt, in dessen Umgebung das Anpassungsstück (107; 311, 315; 403; 604) in der Maximalposition für die Kopplung angeordnet ist.

7. Resonatorfilter (100; 300; 600) nach Anspruch 6, **dadurch gekennzeichnet, dass** die Form des vorstehenden Abschnitts (109; 405) im Wesentlichen mindestens teilweise gleich der Form eines Teils ist, das sich in der Nähe des induktiven Kopplungselements (108; 312, 317; 404; 606) eines Teils des Anpassungsstücks (107; 311, 315; 403; 604) befindet.

8. Resonatorfilter (100; 300; 600) nach einem der Ansprüche 1-7, **dadurch gekennzeichnet, dass** das Anpassungsstück (107; 311, 315; 403; 604) eine Manövrieranordnung (603) besitzt, durch die der Ort des Anpassungsstücks von außerhalb des Resonatorfilters geändert werden kann.

9. Resonatorfilter (100; 300; 600) nach Anspruch 8, **dadurch gekennzeichnet, dass** die Manövrieranordnung (603) dazu ausgelegt ist, mehrere Anpassungsstücke (107; 311, 315; 403; 604) gleichzeitig zu bewegen.

10. Resonatorfilter (100; 300; 600) nach einem der Ansprüche 1-9, **dadurch gekennzeichnet, dass** das Anpassungsstück (107; 311, 315; 403; 604) dazu ausgelegt ist, im Wesentlichen in der longitudinalen Richtung des Filters, d. h. in Richtung der aufeinander folgenden Resonatorhohlräume, beweglich zu sein.

11. Resonatorfilter (100; 300; 600) nach einem der Ansprüche 1-9, **dadurch gekennzeichnet, dass** sich das Anpassungsstück (107; 311, 315; 403; 604) im Wesentlichen an der gleichen Stelle wie das induktive Kopplungselement (110, 313, 316, 406, 605) befindet und der Abstand des Anpassungsstücks zu dem induktiven Kopplungselement dazu ausgelegt ist, angepasst werden zu können.

12. Verfahren zum Anpassen der Kopplung zwischen Resonatorhohlräumen, wobei die Resonatorhohlräume eine Wand, die aus einem Boden, einer Wand und einem Deckel besteht, und ein leitendes Trennelement, das benachbarte Resonatorhohlräume trennt, besitzen und wobei das Trennelement, das anschließende Hohlräume trennt, eine Kopplungsöffnung besitzt, **dadurch gekennzeichnet, dass** durch das Trennelement ein Kopplungsraum gebildet wird, wobei der Kopplungsraum von der Kopplungsöffnung getrennt ist und in beide Resonatorhohlräume, die durch das Trennelement getrennt werden, mündet, wobei sich zwischen den Resonatorhohlräumen ein induktives Kopplungselement befindet, das dazu ausgelegt ist, sich durch den Kopplungsraum in beide Resonatorhohlräume zu erstrecken, und das induktive Kopplungselement in einem der Resonatorhohlräume mit dem Gehäuse in elektrischem Kontakt ist und in dem Kopplungsraum ein bewegliches leitendes Anpassungsstück vorhanden ist, das mindestens eine Minimalposition für die Kopplung und eine Maximalposition für die Kopplung besitzt, und wobei das Verfahren aus Stufen besteht, wobei das Anpassungsstück zwischen der Minimalposition für die Kopplung und der Maximalposition für die Kopplung bewegt wird, wodurch sich das Anpassungsstück in der Maximalposition in der Nähe des induktiven Kopplungselements befindet und es über die kapazitive Kopplung lädt und gleichzeitig die Stärke der Kopplung zwischen den Resonatorhohlräumen erhöht und sich das Anpassungsstück in der Minimalposition für die Kopplung von dem Kopplungselement entfernt befindet und sich seine Auswirkung auf die Kopplung zwischen den Resonatorhohlräumen bei seinem Minimum befindet und wobei das Anpassungsstück entweder an der Position oder an einer anderen Stelle auf dem Pfad des Anpassungsstücks eingestellt ist, um eine gewünschte Stärke für die Kopplung zu erhalten.

## Revendications

1. Filtre de résonateur réglable (100 ; 300 ; 600), qui comporte un boîtier constitué d'un fond (113), de parois (112) et d'un couvercle (203), lequel boîtier fonctionne comme une terre pour un chemin de transmission, lequel boîtier est divisé par des cloisons conductrices (103 ; 309, 310 ; 401 ; 602) en cavités de résonateur (101, 105 ; 304, 402, 407), et il y a sur le chemin de transmission du filtre de résonateur une ouverture de couplage (104 ; 306, 308) dans les cloisons séparant des cavités successives, **caractérisé en ce qu'**il y a dans le boîtier un espace de couplage (108 ; 312, 317 ; 404 ; 606) formé par au moins une des cloisons ayant une ouverture de couplage, lequel espace de couplage est séparé de l'ouverture de couplage et est ouvert dans les deux cavités de résonateur séparées par la cloison, lequel filtre de résonateur comporte au moins un élément de couplage inductif (110 ; 313, 316 ; 406 ; 605) qui est agencé pour s'étendre à travers ledit espace de couplage à l'intérieur des deux cavités de résonateur, et ledit élément de couplage inductif est en contact électrique avec le boîtier dans une des cavités de résonateur, et dans ledit espace de couplage il y a une pièce de réglage conductrice mobile (107 ; 311, 315 ; 403 ; 604) qui a une position minimale pour le couplage et une position maximale pour le couplage, position maximale pour le couplage dans laquelle la pièce de réglage est à proximité immédiate de l'élément de couplage inductif, chargeant l'élément de couplage inductif par le couplage capacitif, et position minimale du couplage dans laquelle la pièce de réglage est à l'écart de l'élément de couplage inductif, et la pièce de réglage est, dans lesdites positions et sur sa trajectoire en dehors de celles-ci, au moins partiellement à l'extérieur des cavités de résonateur ou dans la zone de la cavité de résonateur où les champs électrique et magnétique sont sensiblement à leur minimum.

2. Filtre de résonateur (100 ; 300 ; 600) selon la revendication 1, **caractérisé en ce que** l'espace de couplage (108 ; 312, 317 ; 404 ; 606) se situe dans la paroi du boîtier et s'étend sensiblement depuis le fond jusqu'au couvercle.

3. Filtre de résonateur (100 ; 300 ; 600) selon l'une quelconque des revendications 1 et 2, **caractérisé en ce que** l'élément de couplage inductif (110 ; 313, 316 ; 406 ; 605) a une première extrémité (114) et une deuxième extrémité (115), et il est fixé par sa première extrémité dans la paroi de la cavité de résonateur (101 ; 304 ; 402) et sa deuxième extrémité se situe dans la deuxième cavité de résonateur (105 ; 314 ; 407).

4. Filtre de résonateur (100 ; 300 ; 600) selon la revendication 3, **caractérisé en ce que** la deuxième extrémité (115) de l'élément de couplage inductif (110 ; 313, 316 ; 406 ; 605) est détachée de la paroi de la cavité de résonateur.

5. Filtre de résonateur (100 ; 300 ; 600) selon l'une quelconque des revendications 1 à 4, **caractérisé en ce que** l'élément de couplage inductif (110 ; 313, 316 ; 406 ; 605) est sensiblement séparé électriquement des parois de l'espace de couplage (108 ; 312, 317 ; 404 ; 606).

6. Filtre de résonateur (100 ; 300 ; 600) selon l'une quelconque des revendications 1 à 5, **caractérisé en ce que** l'élément de couplage inductif (110 ; 313, 316 ; 406 ; 605) comporte entre sa première extrémité (114) et sa deuxième extrémité (115), dans sa partie dans l'espace de couplage (108 ; 312, 317 ; 404 ; 606), une partie en saillie (109 ; 405) à proximité de laquelle la pièce de réglage (107 ; 311, 315 ; 403 ; 604) est agencée dans la position maximale pour le couplage.

7. Filtre de résonateur (100 ; 300 ; 600) selon la revendication 6, **caractérisé en ce que** la forme de la partie en saillie (109 ; 405) est sensiblement au moins partiellement la même que la forme d'une partie proche de l'élément de couplage inductif (108 ; 312, 317 ; 404 ; 606) d'une partie de la pièce de réglage (107 ; 311, 315 ; 403 ; 604).

8. Filtre de résonateur (100 ; 300 ; 600) selon l'une quelconque des revendications 1 à 7, **caractérisé en ce que** la pièce de réglage (107 ; 311, 315 ; 403 ; 604) comporte un organe de manoeuvre (603) au moyen duquel la position de la pièce de réglage peut être modifiée depuis l'extérieur du filtre de résonateur.

9. Filtre de résonateur (100 ; 300 ; 600) selon la revendication 8, **caractérisé en ce que** l'organe de manoeuvre (603) est agencé pour déplacer simultanément plusieurs pièces de réglage (107 ; 311, 315 ; 403 ; 604).

10. Filtre de résonateur (100 ; 300 ; 600) selon l'une quelconque des revendications 1 à 9, **caractérisé en ce que** la pièce de réglage (107 ; 311, 315 ; 403 ; 604) est agencée pour être mobile sensiblement dans la direction longitudinale du filtre, c.-à-d. dans la direction des cavités de résonateur successives.

11. Filtre de résonateur (100 ; 300 ; 600) selon l'une quelconque des revendications 1 à 9, **caractérisé en ce que** la pièce de réglage (107 ; 311, 315 ; 403 ; 604) se situe sensiblement sur le même point de l'élément de couplage inductif (110, 313, 316, 406, 605) et la distance de la pièce de réglage à l'élément de couplage inductif est agencée pour être réglable.

12. Procédé de réglage du couplage entre cavités de résonateur, lesquelles cavités de résonateur comportent une paroi qui est composée d'un fond, d'une paroi et d'un couvercle, et une cloison conductrice séparant des cavités de résonateur adjacentes, et la cloison séparant des cavités successives a une ouverture de couplage, **caractérisé en ce qu'**un espace de couplage est formé par la cloison, lequel espace de couplage est séparé de l'ouverture de couplage et est ouvert dans les deux cavités de résonateur séparées par ladite cloison, cavités de résonateur entre lesquelles il y a un élément de couplage inductif qui est agencé pour s'étendre à travers l'espace de couplage à l'intérieur des deux cavités de résonateur, et ledit élément de couplage inductif est en contact électrique avec le boîtier dans une des cavités de résonateur, et il y a dans ledit espace de couplage une pièce de réglage conductrice mobile qui a au moins une position minimale pour le couplage et une position maximale pour le couplage, et le procédé est composé d'étapes où la pièce de réglage est déplacée entre la position minimale pour le couplage et la position maximale pour le couplage, moyennant quoi dans la position maximale la pièce de réglage est près de l'élément de couplage inductif et le charge par le couplage capacitif et augmente simultanément l'intensité du couplage entre les cavités de résonateur, et dans la position minimale pour le couplage la pièce de réglage est à l'écart de l'élément de couplage et son effet sur le couplage entre les cavités de résonateur est à son minimum, et la pièce de réglage est placée dans l'une ou l'autre desdites positions ou à un certain autre point sur la trajectoire de la pièce de réglage afin d'obtenir une intensité souhaitée pour le couplage.
